(19) **Europäisches Patentamt / European Patent Office / Office européen des brevets**

(11) **EP 1 575 304 B1**

(12) **EUROPEAN PATENT SPECIFICATION**

(45) Date of publication and mention
of the grant of the patent:
**15.02.2012 Bulletin 2012/07**

(51) Int Cl.:
***H04N 9/07*** (2006.01)

(21) Application number: **03778803.1**

(86) International application number:
**PCT/JP2003/015859**

(22) Date of filing: **11.12.2003**

(87) International publication number:
**WO 2004/056127 (01.07.2004 Gazette 2004/27)**

(54) **COLOR IMAGING ELEMENT, COLOR FILTER ARRAY, AND COLOR IMAGING DEVICE**

FARBABBILDUNGSELEMENT, FARBFILTERGRUPPE UND FARBABBILDUNGSEINRICHTUNG

ELEMENT D'IMAGERIE EN COULEURS, RESEAU DE FILTRES COLORÉS ET DISPOSITIF
D'IMAGERIE EN COULEURS

(84) Designated Contracting States:
**AT BE BG CH CY CZ DE DK EE ES FI FR GB GR
HU IE IT LI LU MC NL PT RO SE SI SK TR**

(30) Priority: **18.12.2002 JP 2002366296**

(43) Date of publication of application:
**14.09.2005 Bulletin 2005/37**

(73) Proprietor: **NIKON CORPORATION
Chiyoda-ku
Tokyo 100-8331 (JP)**

(72) Inventor: **Hoshuyama, Hideo
Nikon Corp., I.P. Department
Chiyoda-ku, Tokyo 100-8331 (JP)**

(74) Representative: **Zeitler - Volpert - Kandlbinder
Herrnstrasse 44
80539 München (DE)**

(56) References cited:
**EP-A- 1 255 410       JP-A- 3 174 890
JP-A- 2001 016 598**

## Description

*TECHNICAL FIELD*

The present invention relates to a color image sensor and a color filter array which are applied to a color imaging device such as an electronic camera and a video camera, and the color imaging device.

*BACKGROUND ART*

A color image sensor has been conventionally applied to a color imaging device such as an electronic camera and a video camera.

In general, it is preferable for the color imaging device to bring spectral sensitivity characteristics of its imaging optical system from a shooting lens to a color image sensor closer to spectral sensitivity characteristics of the eyes of a human being (or color matching functions which are publicly known) as much as possible.

The color image sensor has a G pixel detecting green light, a B pixel detecting blue light, and an R pixel detecting red light, which are arranged in an array state.

Especially, a Bayer matrix has the G pixels arranged in a checkered pattern and the B pixel and R pixel arranged alternately in gaps between the G pixels. That is, one unit (pixel block) is constituted of the four pixels made of the two G pixels, one B pixel, and one R pixel.

Incidentally, the reason why the number of the G pixels is greater than the R pixel and B pixel is as follows.

One of characteristics of the eyes of the human being is that the number of cells detecting green is greater than the number of cells detecting other colors. Accordingly, the eyes of the human being have wide detection luminance range of the green light. Accordingly, when a large quantity of the G pixels are provided in the image sensor, it is possible to extend the detection luminance range (what is called dynamic range) similarly to the eyes of the human being.

Meanwhile, since color range to be discriminated by the three kinds of pixels, which are the R pixel, G pixel, and B pixel, is slightly narrower than the color range to be discriminated by the eyes of the human being, two different colors for the eyes of the human being are sometimes detected as the same color.

Therefore, a color image sensor of a multiband type in which another type of pixel is further added has been recently proposed (for example, a color image sensor described in Patent Document 1 = Japanese Patent Application Laid-Open No. JP-A 2002-271804).

According to the color image sensor of the multiband type described in the Patent Document 1, a Y pixel detecting color between green and red (yellow) is added in addition to the R pixel, G pixel, and B pixel, to thereby enlarge detection color range.

However, according to the conventional color image sensor of the multiband type, it is necessary to reduce the number of the G pixels from two to one, in order to add the Y pixel into the pixel block. Therefore, there are tendencies that the detection luminance range of the green light is reduced and the detection luminance range of the color image sensor is reduced.

Incidentally, this problem is not caused when the color image sensor is changed to a multi-board type because the Y pixel can be added without reducing the number of the G pixels, but it is not so suitable for the electronic camera and video camera requiring downsizing, because an arrangement space is increased from the necessity for branching an optical path and arranging the image sensor for each branched path.

Further, this problem is not caused when a rotary switching filter is applied because the Y pixel can be added without reducing the number of the G pixels, but it is not so suitable for the electronic camera and video camera requiring downsizing, because the arrangement

space is increased similarly to the case of the multi-board type.

Documents JP-A-2001016598 and JP-A-3174890 disclose a color imaging device comprising second green color component G2 having a peak sensitivity near the peak of a minus sensitivity of the red of an ideal sensitivity.

*DISCLOSURE OF THE INVENTION*

For this reason, it is an object of the present invention to provide a single board type color image sensor which can suppress the reduction of detection luminance range while enlarging detection color range.

Further, it is an object of the present invention to provide a color filter array which can suppress the reduction of the detection luminance range while enlarging the detection color range, in constituting the single board type color image sensor.

Further, it is an object of the present invention to provide a color imaging device which can suppress the reduction of the detection luminance range while enlarging the detection color range.

A color imaging device according to the present invention is defined in claim 1. It comprises a color image sensor in which pixel blocks are arranged in an array state, comprising a first pixel detecting red light, a second pixel detecting green light, a third pixel detecting blue light, and a fourth pixel detecting light having a wavelength between the green light and the blue light or between the green light and the red light, wherein sensitivity of the fourth pixel to the above-mentioned light is kept lower than sensitivity of the second pixel to the green light.

By combining these four kinds of pixels, the detection color range is enlarged. Further, when an output of the fourth pixel is referred to in addition to an output of the second pixel, it is possible to detect the high-level green light. Accordingly, the reduction of the detection luminance range can be suppressed while enlarging the detection color range.

Preferably, the sensitivity of the fourth pixel is kept to about half the sensitivity of the second pixel. Thereby, the effect of "enlarging the detection color range" and the effect of "suppressing the reduction of the detection luminance range" can be obtained equally.

Further preferably, a peak wavelength of a sensitivity characteristic of the first pixel is within the range from 590 nm to 640 nm, a peak wavelength of a sensitivity characteristic of the second pixel is within the range from 520 nm to 570 nm, a peak wavelength of a sensitivity characteristic of the third pixel is within the range from 430 nm to 480 nm, and a peak wavelength of a sensitivity characteristic of the fourth pixel is within the range from 490 nm to 530 nm or the range from 560 nm to 640 nm.

A color filter array according to an example comprises filter blocks arranged in an array state, comprising a first filter unit limiting incident visible light to red light, a second filter unit limiting the incident visible light to green, a third filter unit limiting the incident visible light to blue light, and a fourth filter unit limiting the incident visible light to light having a wavelength between the green light and the blue light or between the green light and the red light, wherein transmittance of the fourth filter unit to the above-mentioned light is kept lower than transmittance of the second filter unit to the green light.

According to the color filter array in which these four kinds of filter units are combined, the detection color range of the color mage sensor is enlarged. Further, when an output of the pixel opposing the fourth filter unit is referred to in addition to an output of the pixel opposing the second filter unit of the color image sensor, it is possible to detect the high-level green light. Accordingly, when this color filter array is used, the color image sensor which can suppress the reduction of the detection luminance range while enlarging the detection color range is realized.

Preferably, the transmittance of the fourth filter unit is kept to about half the transmittance of the second filter unit. Thereby, the effect of "enlarging the detection color range" and the effect of "suppressing the reduction of the detection luminance range" can be obtained equally.

Further preferably, a peak wavelength of a transmittance characteristic of the first filter unit in a visible light region is within the range from 590 nm to 640 nm, a peak wavelength of a transmittance characteristic of the second filter unit in the visible light region is within the range from 520 nm to 570 nm, a peak wavelength of a transmittance characteristic of the third filter unit in the visible light region is within the range from 430 nm to 480 nm, and a peak wavelength of a transmittance characteristic of the fourth filter unit in the visible light region is within the range from 490 nm to 530 nm or the range from 560 nm to 640 nm.

According to the color imaging device as above, it is possible to bring out the effects of the color image sensor of the present invention without fail.

_BRIEF DESCRIPTION OF DRAWINGS_

Fig. 1 is a view showing schematic structure of an electronic camera of this embodiment;
Figs. 2 are views explaining a color image sensor 11 of this embodiment;
Fig. 3 is a view showing spectral sensitivity characteristics of the color image sensor 11 of this embodiment;
Fig. 4 is a view showing color matching functions (publicly known); and
Fig. 5 is a view explaining the procedure of the processing by a color transformation matrix decision circuit 13.

_BEST MODE FOR CARRYING OUT THE INVENTION_

Embodiments according to the present invention will be described below with reference to the accompanying drawings.

(EMBODIMENT)

This embodiment relates to an electronic camera (corresponding to a color imaging device of the present invention) to which a color image sensor of the present invention or a color filter array of the present invention is applied.

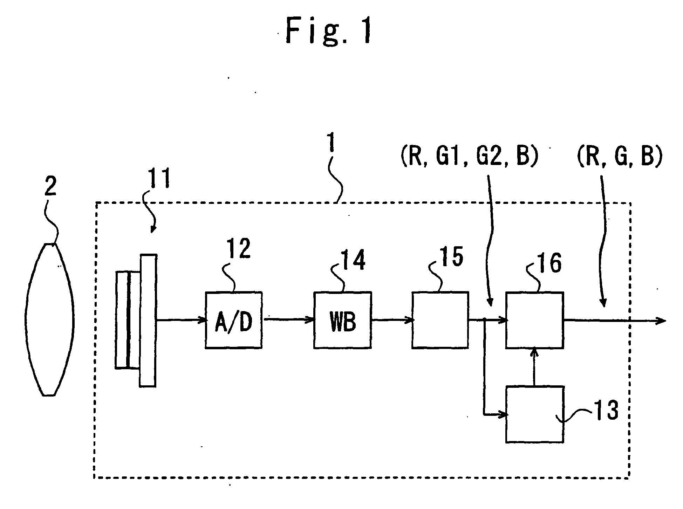

Fig. 1 is a view showing schematic structure of the electronic camera of this embodiment.

The electronic camera is constituted of, for example, an electronic camera body 1 and a shooting lens 2.

The electronic camera body 1 is provided with a color image sensor 11, an A/D converter 12, a white balance processing circuit 14, a color interpolation circuit 15, a color transformation circuit 16, a color transformation matrix decision circuit 13 (corresponding to a signal processing unit) and the like.

A subject image by the shooting lens 2 is formed on the color image sensor 11. An output signal from the color image sensor 11 is inputted into the A/D converter 12 via a not-shown analog gain controller, and converted into a digital signal. The digital signal is subjected to white balance processing in the white balance processing circuit 14, color interpolation processing in the interpolation circuit 15, gray-scale transformation processing in the color transformation circuit 16, and then stored in a not-shown memory.

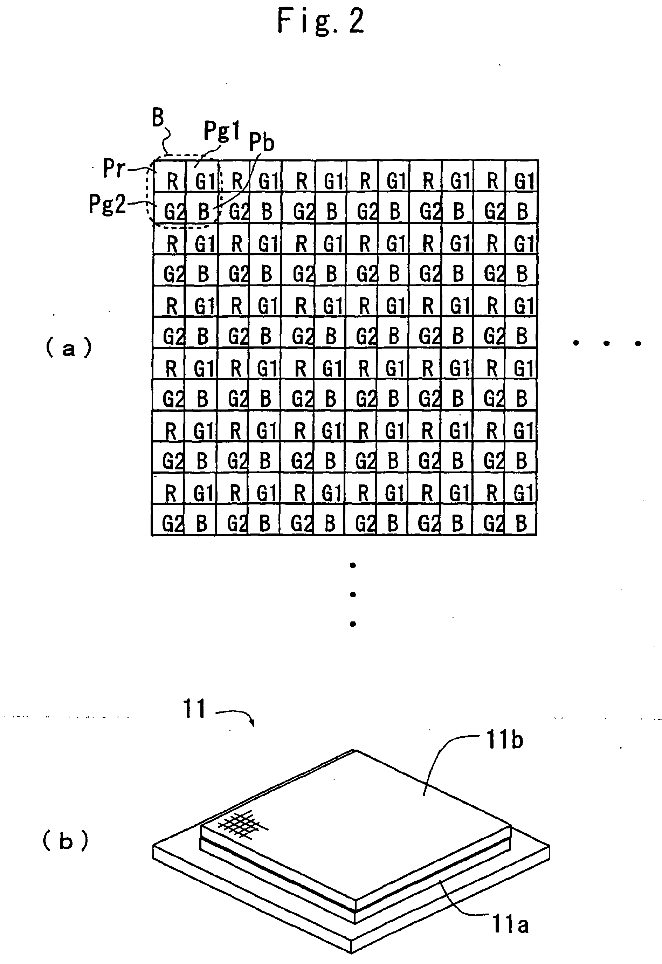

Figs. 2 are views explaining the color image sensor 11 of this embodiment.

Fig. 2(a) is a view explaining respective pixel blocks B and respective pixels P of the color image sensor 11, and Fig. 2(b) is a view showing a structural example of the color image sensor 11.

As shown in Fig. 2(a), the pixel blocks B are arranged in an array state on an imaging surface of the color image sensor 11.

Each pixel block B has an R pixel Pr for detecting red light (corresponding to a first pixel), a G1 pixel Pg1 for detecting green light (corresponding to a second pixel), a B pixel Pb for detecting blue light (corresponding to a third pixel), and a G2 pixel Pg2 for detecting light having a wavelength between the green light and blue light (corresponding to a fourth pixel) which are arranged in a cross shape.

The sensitivity of the G2 pixel Pg2 to the above-mentioned light is set lower than the sensitivity of the G1 pixel Pg1 to the green light.

Incidentally, it is preferable that the G1 pixel Pg1 and the G2 pixel Pg2 are arranged to have the relation unadjacent to each other in each pixel block B (that is, upper right-lower left relation as shown in the drawing, or upper left-lower right relation).

The reason is that, as will be described later, the electronic camera of this embodiment may treat an output of the G1 pixel Pg1 and an output of the G2 pixel Pg2 as the outputs of the pixels of different kinds or the outputs of the pixels of the same kind, and therefore it is preferable that the G1 pixel Pg1 and the G2 pixel Pg2 are arranged alternately and in a checkered pattern on the imaging surface.

The color image sensor 1 like the above is constituted by, for example, preparing an image sensor 11a for capturing a visible light image (which is hereinafter a monochrome image sensor in which characteristics of respective pixels are equal to each other) and arranging a color filter array 11b on the incident side of the image sensor 11a.

The color filter array 11b has filter blocks arranged in an array state, and each of the filter blocks has an R filter unit for limiting the incident visible light to the red light, a G1 filter unit for limiting the incident visible light to green, a B filter unit for limiting the incident visible light to the blue light, and a G2 filter unit for limiting the incident visible light to the light having the wavelength between the green light and the blue light, being arranged.

Among the above units, the transmittance of the G2 filter unit to the above-mentioned light is set lower than the transmittance of the G1 filter unit to the green light.

According to this color filter array 11b, the pixel of the image sensor 11b opposing the R filter unit can be used as the R pixel Pr for detecting the red light, the pixel opposing the G1 filter unit can be used as the G1 pixel Pg1 for detecting the green light, the pixel opposing the B filter unit can be used as the B pixel Pb for detecting the blue light, and the pixel opposing the G2 filter unit can be used as the G2 pixel Pg2 for detecting the light having the wavelength between the green light and the blue light.

Incidentally, it is preferable that the G1 filter unit and the G2 filter unit are arranged to have the relation unadjacent to each other in each filter block (that is, upper right-lower left relation or upper left-lower right relation), in order to arrange the G1 pixel Pg1 and the G2 pixel Pg2 in the checkered pattern.

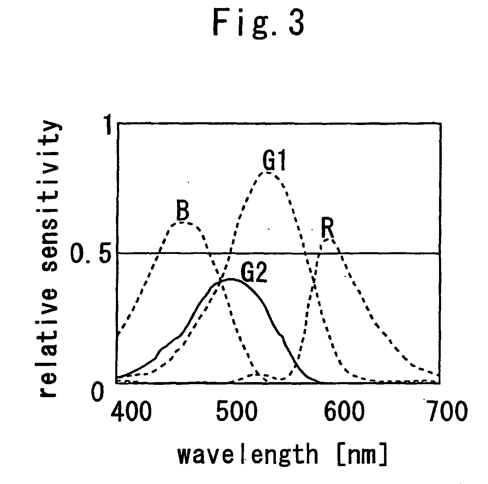

Fig. 3 is a graph showing spectral sensitivity characteristics of the color image sensor 11 of this embodiment.

In Fig. 3, the curve denoted by the symbol "R" corresponds to a sensitivity characteristic curve of the R pixel Pr, the curve denoted by the symbol "G1" corresponds to a sensitivity characteristic curve of the G1 pixel Pg1, the curve denoted by the symbol "B" corresponds to a sensitivity characteristic curve of the B pixel Pb, and the curve denoted by the symbol "G2" corresponds to a sensitivity characteristic curve of the G2 pixel Pg2.

A peak wavelength of the sensitivity characteristic of the R pixel Pr for detecting the red light is within the range from 590 nm to 640 nm, a peak wavelength of the sensitivity characteristic of the G1 pixel Pg1 for detecting the green light is within the range from 520 nm to 570 nm, and a peak wavelength of the sensitivity characteristic of the B pixel Pb for detecting the blue light is within the range from 430 nm to 480 nm.

Further, a peak wavelength of the sensitivity characteristic of the G2 pixel Pg2 for detecting the light between the blue light and the green light is within the range from 490 nm to 530 nm.

For example, the peak wavelength of the sensitivity characteristic of the R pixel Pr is 600 nm, the peak wavelength of the sensitivity characteristic of the G1 pixel Pg1 is 540 nm, the peak wavelength of the sensitivity characteristic of the B pixel Pb is 460 nm, and the peak wavelength of the sensitivity characteristic of the G2 pixel Pg2 is 500 nm.

It should be noted that spectral transmittance characteristics of the color filter array 11b for adding such spectral sensitivity characteristics to the color image sensor 11 are as follows.

A peak wavelength of the transmittance characteristic of the R filter unit of the color filter array 11b is within the range from 590 nm to 640 nm, a peak wavelength of the sensitivity characteristic of the G1 filter unit is within the range from 520 nm to 570 nm, and a peak wavelength of the sensitivity characteristic of the B filter unit is within the range from 430 nm to 480 nm.

Further, a peak wavelength of the sensitivity characteristic of the G2 filter unit is within the range from 490 nm to 530 nm.

For example, the peak wavelength of the transmittance characteristic of the R filter unit is 600 nm, the peak wavelength of the transmittance characteristic of the G 1 filter unit is 540 nm, the peak wavelength of the transmittance characteristic of the B filter unit is 460 nm, and the peak wavelength of the transmittance characteristic of the G2 filter unit is 500 nm.

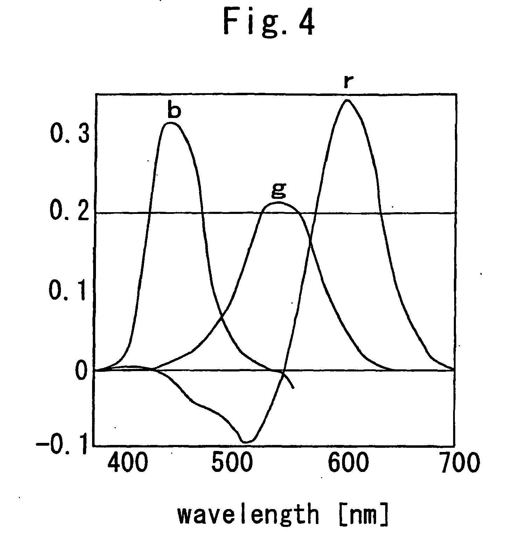

Fig. 4 is a graph showing color matching functions (publicly known).

The symbols "r", "g" and "b" denote the color matching functions in RGB color system r, g and b, respectively.

As is clear from the comparison between Fig. 3 and Fig. 4, the sensitivity characteristic of the R pixel, the sensitivity characteristic of the G1 pixel, and the sensitivity characteristic of the B pixel of this embodiment correspond to the color matching function r, the color matching function g and the color matching function b, respectively.

It should be noted that the color matching function r has not only a positive peak, but also a negative peak.

The sensitivity characteristic of the G2 pixel of this embodiment has its peak at the position corresponding to the negative peak of the color matching function r.

Therefore, color detection in color range which is almost the same as the color range shown by the color matching functions r, g and b (that is, the color range detectable by the eyes of a human being) is possible, based on the output value of the R pixel, the output value of the G1 pixel, the output value of the B pixel, and an opposite sign of the output value of the G2 pixel.

Moreover, as is clear from Fig. 3, the sensitivity of the G2 pixel is positively set lower than the sensitivity of the G1 pixel. For example, it is preferable that the sensitivity of the G2 pixel is about half the sensitivity of the G1 pixel.

By setting as above, a saturation level of the G2 pixel (value showing the upper limit of detectable luminance) becomes higher than a saturation level of the G1 pixel (value showing the upper limit of detectable luminance), and is set approximately twice as high.

Meanwhile, the color interpolation circuit 15 shown in Fig. 1 performs color interpolation based on an output signal R of the R pixel Pr, an output signal G1 of the G1 pixel Pg1, an output signal B of the B pixel Pb, and an output signal G2 of the G2 pixel Pg2 (incidentally, these are the output signals after the A/D conversion and white balance processing), and generates signals (R, G1, G2 and B) showing respective color components of the light incident on each pixel (pixel signals).

Incidentally, the G1 component, G2 component, and B component in the pixel signal of the R pixel in a pixel block B are respectively obtained based on the respective output signals of the G1 pixel, G2 pixel, and B pixel in the surrounding pixel block.

Similarly, the R component, G2 component, and B component in the pixel signal of the G1 pixel in a pixel block B are respectively obtained based on the respective output signals of the R pixel, G2 pixel, and B pixel in the surrounding pixel block.

Similarly, the R component, G1 component, and B component in the pixel signal of the G2 pixel in a pixel block B are respectively obtained based on the respective output signals of the R pixel, G1 pixel, and B pixel in the surrounding pixel block.

Similarly, the R component, G1 component, and G2 component in the pixel signal of the B pixel in a pixel block B are respectively obtained based on the respective output signals of the R pixel, G1 pixel, and G2 pixel in the surrounding pixel block.

Next, the color transformation circuit 16 subjects the pixel signals (R, G1, G2 and B) to the color transformation by multiplying these by a color transformation matrix M of 3 x 4, as shown in the expression (1), to generate color signals for display (R, G and B).

$$
\begin{bmatrix} R \\ G \\ B \end{bmatrix} = M \begin{bmatrix} R \\ G1 \\ G2 \\ B \end{bmatrix} \quad \cdots (1)
$$

Here, the color transformation matrix M to be multiplied by the color transformation circuit 16 of this embodiment is any one of a matrix A, matrix B, and matrix C. The matrix A, matrix B or matrix C is set selectively by the color transformation matrix decision circuit 13.

In selecting, the color transformation matrix decision circuit 13 refers to the G1 component of the pixel signals (R, G1, G2 and B) and makes a selection based on the value of the G1 component. Further, as a result of the selection, the color transformation matrix decision circuit 13 performs white balance reprocessing if necessary (as will be described later in detail).

The matrixes A, B and C are expressed by the expressions (2), (3) and (4), for example.

$$
A = \begin{bmatrix} 0.60 & 0.66 & -1.25 & 0.31 \\ 0.23 & 1.15 & -0.87 & 0.04 \\ -0.02 & 0.14 & -0.65 & 1.01 \end{bmatrix} \quad \cdots (2)
$$

$$
B = \begin{bmatrix} 0.64 & 0.44 & -0.63 & 0.18 \\ 0.26 & 1.00 & -0.43 & -0.05 \\ 0.00 & 0.03 & -0.32 & 0.94 \end{bmatrix} \quad \cdots (3)
$$

$$
C = \begin{bmatrix} 0.67 & 0 & 0.23 & 0.06 \\ 0.28 & 0 & 0.85 & -0.14 \\ 0.02 & 0 & -0.09 & 0.88 \end{bmatrix} \quad \cdots (4)
$$

As is clear from the reference to the expressions (2) and (3), the matrix A or the matrix B reflects the respective components of the pixel signals (R, G1, G2 and B) in the color signals (R, G and B).

Here, as shown in Fig. 3, the peaks of the sensitivity characteristic of the G 1 pixel and the sensitivity characteristic of the G2 pixel are close to each other. Therefore, the G1 component and G2 component show a subtle color difference precisely.

Accordingly, the matrix A or matrix B reflects the subtle color difference of the pixel signals (R, G1, G2 and B) in the color signals (R, G and B) precisely.

Incidentally, since the sign of the component in the first line and third column (coefficient of G2) is negative in either the matrix A or the matrix B, the bigger the G2 component of the pixel signals (R, G1, G2 and B), the smaller the R component of the color signals (R, G and B) relatively. Thereby, color reproduction by the color signals (R, G and B) similar to color reproduction by the color matching functions r, g and b (refer to Fig. 4, in which the negative peak is between blue and green) is possible.

Meanwhile, as is clear from the reference to the expression (4), the matrix C regards the G2 component as the signal showing green, instead of the G1 component of the pixel signals (R, G1, G2 and B), and reflects the R component, G2 component, and B component in the color signals (R, G and B).

Here, as mentioned above, the peaks of the sensitivity characteristic of the G1 pixel and the sensitivity characteristic of the G2 pixel are close to each other, and the saturation level of the G2 pixel is higher than the saturation level of the G 1 pixel (twice as high). Accordingly, the G2 component shows the luminance of the color close to the color shown by the G 1 component (green) precisely up to the level higher than the G 1 component.

Therefore, the matrix C reflects the high level luminance of the pixel signals (R, G1, G2 and B) in the color signals (R, G and B) precisely.

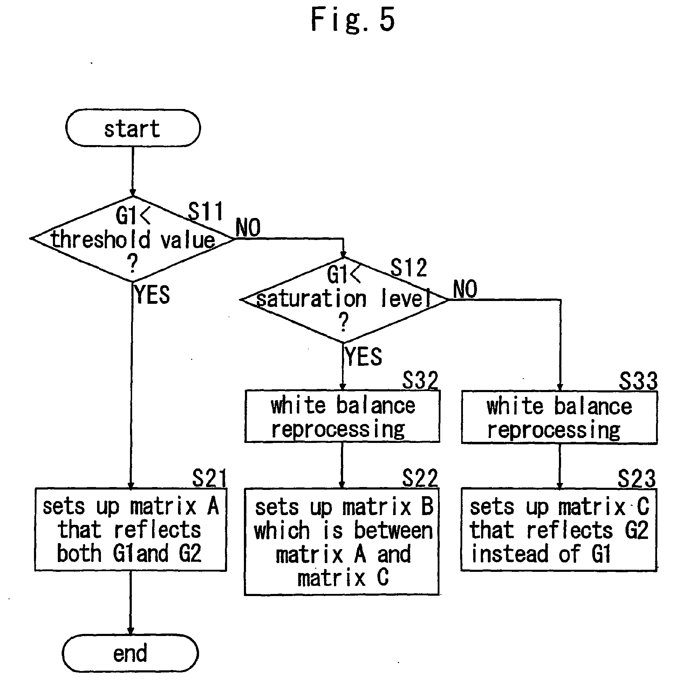

Fig. 5 is a flowchart explaining the procedure of the processing by the color transformation matrix decision circuit 13.

The color transformation matrix decision circuit 13 refers to the G1 component of the pixel signals (R, G1, G2 and B).

Then, when the value of the G1 component does not exceed the saturation level (value corresponding to the saturation level of the output signal of the G1 pixel, which is 3500, for example) (YES in a step S11, or NO and YES in a step S12), it selects the matrix A or the matrix B which reflects the subtle color difference precisely (a step S21 or step S22), and when the value of the G1 component exceeds the saturation level (3500, for example) (NO in the step S11 and NO in the step S12), it selects the matrix C which reflects the high level luminance precisely (a step S23).

That is, according to this embodiment, when the G1 component of the pixel signals (R, G1, G2 and B) does not exceed the saturation level of the G1 pixel (YES in the step S11, or NO in the step S11 and YES in the step S12), the detection color range enlarges, and when the value of the G1 component of the pixel signals (R, G 1, G2 and B) exceeds the saturation level of the G1 pixel (NO in the step S11 and NO in the step S12), the high luminance can be detected precisely although the detection color range does not enlarge. Therefore, reduction of the detection luminance range can be suppressed while enlarging the detection color range.

Incidentally, when comparing the matrix B and matrix A as shown in the expressions (2) and (3), the absolute values of the coefficients in the second column (coefficients of G1) and the coefficients in the third column (coefficients of G2) of the matrix B are smaller than those of the matrix A as a whole (the matrix B has the smaller reflection amount of the G1 components and the smaller negative reflection amount of the G2 components than the matrix A).

That is, the matrix B performs the color transformation between the matrix A and the matrix C (the reflection amount of the G1 components is 0 and the reflection amount of the G2 components is large).

Accordingly, as shown in Fig. 5, it is preferable that the matrix A is selected (a step S21) when the value of the G1 component is lower than a threshold value (3000, for example) which is smaller than the saturation level (YES in the step S11), and the matrix B is selected (a step S22) when it is higher than the threshold value and lower than the saturation level (NO in the step S11 and YES in the step S11).

Thus, when the three kinds of matrixes, not only the matrix C and matrix A but also the matrix B which is between the two, are used appropriately, it is possible to prevent the color transformation from changing drastically corresponding to the difference in the G 1 component, and unnatural expressions from appearing on the reproduced image.

Incidentally, the white balance gain to be multiplied by the respective signals by the white balance processing circuit 14 (refer to Fig. 1) is supposed to be an optimum value when using the matrix A.

In this case, when the matrix B is used and the matrix C is used, it is preferable that the white balance reprocessing is performed before the step S22 and the step S23 are performed (steps S32 and S33).

Incidentally, the white balance gain to be multiplied in the white balance reprocessing in the step S32 is an optimum value when using the matrix B instead of the matrix A, and the white balance gain to be multiplied in the white balance reprocessing in the step S33 is an optimum value when using the matrix C instead of the matrix A.

(OTHERS)

Incidentally, although the sensitivity of the G2 pixel is "half" the sensitivity of the G1 pixel in the above-described embodiment, processing attaching a higher value to "enlargement of the detection color range" than "suppressing the reduction of the detection luminance range" is possible when it is set to be slightly larger than the half, and processing attaching a higher value to "suppressing the reduction of the detection luminance range" than "enlargement of the detection color range" is possible when it is set to be slightly smaller than the half. It is preferable that the relation between the G2 sensitivity and the G1 sensitivity is decided by taking a balance between the two in consideration.

Further, although the detection color of the G2 pixel is the color between blue and green in the above-described embodiment, the same effects as those of the above-described embodiment can be obtained even when it is changed to color between green and red, as long as its sensitivity is set lower than the G1 pixel (preferably about a half). It should be noted that the contents of the color transformation matrixes (values of matrix elements) are changed appropriately according to the sensitivity characteristic of the G2 pixel.

Moreover, although the color image sensor in which the color filter array and the monochrome image sensor are combined is exemplified in the above-described embodiment, it is possible to use a color image sensor which does not use the color filter. Further, when a new color filter array is arranged on a conventional color image sensor (such as a color image sensor having a Bayer matrix and the like), it is also possible to add the spectral sensitivity characteristics similar to those of the color image sensor according to the above-described embodiment.

*INDUSTRIAL APPLICABILITY*

According to an example, a single board type color image sensor which can suppress the reduction of the detection luminance range while enlarging the detection color range is realized.

Further, according to a further example, the color filter array which can suppress the reduction of the detection luminance range while enlarging the detection color range is realized, when the single board type color image sensor is constituted.

Furthermore, according to the present invention, the color imaging device which can suppress the reduction of the detection luminance range while enlarging the detection color range is realized.

**Claims**

1. Color imaging device comprising:

   a color image sensor in which pixel blocks (B) are arranged in an array state,
   a signal processing unit (11 - 16) for generating color signals based on respective outputs of a first pixel (Pr), second pixel (Pg1), and third pixel (Pb),

   wherein
   said pixel blocks (B) include:

   said first pixel (Pr) for detecting red light;
   said second pixel (Pg1) for detecting green light;
   said third pixel (Pb) for detecting blue light; and

   a fourth pixel (Pg2) for detecting light having one of wavelengths between the green light and the blue light and between the green light and the red light,
   light-receiving sensitivity of said second pixel (Pg1) is set higher than light-receiving sensitivity of any one of said first pixel (Pr), said third pixel (Pb) and said fourth pixel (Pg2), and
   said signal processing unit (11 - 16) generates the color signals based on four color components (R, G1, G2 and B) which are the output of said fourth pixel (Pg2) and said respective outputs when the output of said second pixel (Pg1) does not reach a saturation level, and generates the color signals based on three color components which are the output of said fourth pixel (Pg2) and said respective outputs excluding the output of said second pixel (Pg1) when the output of said second pixel (Pg1) reaches the saturation level.

2. Color imaging device according to claim 1, **characterized in that** the sensitivity of said fourth pixel (Pg2) is set to about half the sensitivity of said second pixel (Pg1).

3. Color imaging device according to claim 1 or 2, **characterized in that** a peak wavelength of a sensitivity characteristic of said first pixel (Pr) is within the range from 590 nm to 640 nm; a peak wavelength of a sensitivity characteristic of said second pixel (Pg1) is within the range from 520 nm to 570 nm; a peak wavelength of a sensitivity characteristic of said third pixel (Pb) is within the range from 430 nm to 480 nm; and a peak wavelength of a sensitivity characteristic of said forth pixel (Pg2) is within one of the ranges from 490 nm to 530 nm and from 560 nm to 640 nm.

4. Color imaging device according to one of claims 1 to 3, **characterized in that** a sensitivity characteristic of said first pixel (Pr) is set by a transmittance characteristic of a first filter unit provided in said first pixel (Pr), a sensitivity characteristic of said second pixel (Pg1) is set by a transmittance characteristic of a second filter unit provided in said second pixel (Pg1), a sensitivity characteristic of said third pixel (Pb) is set by a transmittance characteristic of a third filter unit provided in said third pixel (Pb), and a sensitivity characteristic of said fourth pixel (Pg2) is set by a transmittance characteristic of a fourth filter unit provided in said fourth pixel (Pg2).

5. Color imaging device according to claim 4, **characterized in that** transmissivity of said fourth filter unit is set to about half transmissivity of said second filter unit.

6. Color imaging device according to claim 4 or 5, **char-**

**acterized in that** a peak wavelength of the transmittance characteristic of said first filter unit in a visible light region is within the range from 590 nm to 640 nm; a peak wavelength of the transmittance characteristic of said second filter unit in the visible light region is within the range from 520 nm to 570 nm; a peak wavelength of the transmittance characteristic of said third filter unit in the visible light region is within the range from 430 nm to 480 nm; and a peak wavelength of the transmittance characteristic of said fourth filter unit in the visible light region is within one of the ranges from 490 nm to 530 nm and from 560 nm to 640 nm.

7.  Signal processing method applied to a color imaging device comprising a color image sensor, in which pixel blocks (B) are arranged in an array state, said pixel blocks (B) include:

    said first pixel (Pr) for detecting red light;
    said second pixel (Pg1) for detecting green light;
    said third pixel Pb) for detecting blue light; and
    a fourth pixel (Pg2) for detecting light having one of wavelengths between the green light and the blue light and between the green light and the red light,
    light-receiving sensitivity of said second pixel (Pg1) is set higher than light-receiving sensitivity of any one of said first pixel (Pr), said third pixel (Pb) and said fourth pixel (Pg2),

    said signal processing method comprising:

    a signal processing step generating color signals based on respective outputs of a first pixel (Pr), second pixel (Pg1) and third pixel (Pb), wherein
    in said signal processing step, the color signals are generated based on four color components (R, G1, G2 and B) which are the output of said fourth pixel (Pg2) and said respective outputs when the

    output of said second pixel (Pg1) does not reach a saturation level, and the color signals
    are generated based on three color components which are the output of said fourth pixel (Pg2) and said respective outputs excluding the output of said second pixel (Pg1) only when the output of said second pixel (Pg1) reaches the saturation level.

8.  Signal processing method according to claim 7, **characterized in that** the sensitivity of said fourth pixel (Pg2) is set to about half the sensitivity of said second pixel (Pg1).

9.  Signal processing method according to claim 7 or 8, **characterized in that** a peak wavelength of a sensitivity characteristic of said first pixel (Pr) is within the range from 590 nm to 640 nm; a peak wavelength of a sensitivity characteristic of said second pixel (Pg1) is within the range from 520 nm to 570 nm; a peak wavelength of a sensitivity characteristic of said third pixel (Pb) is within the range from 430 nm to 480 nm; and a peak wavelength of a sensitivity characteristic of said fourth pixel (Pg2) is within one of the ranges from 490 nm to 530 nm and from 560 nm to 640 nm.

**Patentansprüche**

1.  Farbabbildungsvorrichtung, umfassend einen Farbbildsensor, bei dem die Pixelblöcke (B) in einem Reihenzustand angeordnet sind, eine Signalverarbeitungseinheit (11 - 16) zur Erzeugung von Farbsignalen, basierend auf entsprechenden Ausgängen eines ersten Pixels (Pr), eines zweiten Pixels (Pg1) und eines dritten Pixels (Pb), wobei die Pixelblöcke (B) enthalten: den ersten Pixel (Pr) zur Feststellung von Rotlicht, den zweiten Pixel (Pg1) zur Feststellung von Grünlicht, den dritten Pixel (Pb) zur Feststellung von Blaulicht, und einen vierten Pixel (Pg2) zur Lichtfeststellung, das eine Wellenlänge hat, die zwischen den Wellenlängen des Grünlichts und des Blaulichts und zwischen denen des Grünlichts und des Rotlichts liegt, wobei die Empfindlichkeit des Lichtempfangs des zweiten Pixels (Pg1) höher liegt als die Empfindlichkeit des Lichtempfangs irgendeines Pixels der genannten Gruppe aus erstem Pixel (Pr), drittem Pixel (Pb) und viertem Pixel (Pg2), und wobei ferner die Signalverarbeitungseinheit (11 - 16) die Farbsignale erzeugt, die sich auf vier Farbkomponenten (R, G1, G2 und B) stützen, welche der Ausgang des genannten vierten Pixels (Pg2) und die entsprechenden Ausgänge sind, und der Ausgang des genannten zweiten Pixels (Pg1) kein Sättigungsniveau erreicht und auf der Grundlage von drei Farbkomponenten, die der Ausgang des vierten Pixels (Pg2) sind, die Farbsignale erzeugt, und wobei die genannten entsprechenden Ausgänge den Ausgang des genannten zweiten Pixels (Pg1) ausschließen, wenn der Ausgang des genannten zweiten Pixels (Pg1) das Sättigungsniveau erreicht.

2.  Farbabbildungsvorrichtung nach Anspruch 1, **dadurch gekennzeichnet, dass** die Empfindlichkeit des vierten Pixels (Pg2) auf etwa die halbe Empfindlichkeit des zweiten Pixels (Pg1) eingestellt ist.

3.  Farbabbildungsvorrichtung nach Anspruch 1 oder 2, **dadurch gekennzeichnet, dass** eine Wellenlängenspitze einer Empfindlichkeitscharakteristik des ersten Pixels (Pr) im Bereich von 590 nm bis 640 nm liegt; dass eine Wellenlängenspitze einer Empfindlichkeitscharakteristik des zweiten Pixels (Pg1) innerhalb des Bereiches von 520 nm bis 570 nm liegt; dass eine Wellenlängenspitze einer Empfindlichkeitscharakteristik des dritten Pixels (Pb) innerhalb des Bereiches von 430 nm bis 480 nm liegt; dass eine Wellenlängenspitze einer Empfindlichkeitscharakteristik des vierten Pixels (Pg2) in einem der Bereiche von 490 nm bis 530 nm und von 560 nm bis 640 nm liegt.

4. Farbabbildungsvorrichtung nach einem der Ansprüche 1 bis 3, **dadurch gekennzeichnet, dass** eine Empfindlichkeitscharakteristik des ersten Pixels (Pr) durch eine Durchgangscharakteristik einer ersten Filtereinheit eingestellt wird, die in dem ersten Pixel (Pr) vorhanden ist, dass eine Empfindlichkeitscharakteristik des zweiten Pixels (Pg1) durch eine Durchgangscharakteristik einer zweiten Filtereinheit in dem zweiten Pixel (Pg1) eingestellt wird, dass eine Empfindlichkeitscharakteristik des dritten Pixels (Pb) durch eine Durchgangscharakteristik einer dritten Filtereinheit eingestellt wird, die in dem dritten Pixel (Pb) vorgesehen ist, und dass eine Empfindlichkeitscharakteristik des vierten Pixels (Pg2) durch eine Durchgangscharakteristik einer vierten Filtereinheit eingestellt wird, die in dem vierten Pixel (Pg2) vorgegeben ist.

5. Farbabbildungsvorrichtung nach Anspruch 4, **dadurch gekennzeichnet, dass** die Durchlässigkeit der vierten Filtereinheit auf etwa die halbe Durchlässigkeit der zweiten Filtereinheit eingestellt ist.

6. Farbabbildungsvorrichtung nach Anspruch 4 oder 5, **dadurch gekennzeichnet, dass** eine Wellenlängenspitze der Durchgangscharakteristik der ersten Filtereinheit in einem sichtbaren Lichtbereich in einem Bereich von 590 nm bis 640 nm liegt, dass eine Wellenlängenspitze der Durchgangscharakteristik der zweiten Filtereinheit in der sichtbaren Lichtzone in dem Bereich von 520 nm bis 570 nm liegt; dass eine Wellenlängenspitze der Durchlässigkeitscharakteristik der dritten Filtereinheit in der sichtbaren Lichtzone innerhalb des Bereiches von 430 nm bis 480 nm liegt; und dass eine Wellenlängenspitze der Durchlässigkeitscharakteristik der vierten Filtereinheit in der sichtbaren Lichtzone innerhalb eines der Bereiche von 490 nm bis 530 nm und von 560 nm bis 640 nm liegt.

7. Signalverarbeitungsverfahren, angewandt auf eine Farbabbildungsvorrichtung, die einen Farbbildsensor aufweist, in dem Pixelblöcke (B) in einem Reihenzustand angeordnet sind, wobei die Pixelblöcke (B) das ersten Pixel (Pr) zur Feststellung von Rotlicht; das zweite Pixel (Pg1) zur Feststellung von grünem Licht; das dritte Pixel (Pb) zur Feststellung von Blaulicht; und ein viertes Pixel (Pg2) zur Feststellung von Licht mit einer der Wellenlängen, die zwischen dem Grünlicht und dem Blaulicht und zwischen dem Grünlicht und dem Rotlicht liegt, aufweist, und die Lichtempfangsempfindlichkeit des zweiten Pixels (Pg1) höher eingestellt wird, als die Lichtempfangsempfindlichkeit des ersten Pixels (Pr) oder des dritten Pixels (Pb) oder des vierten Pixels (Pg2), wobei ein Signalverarbeitungsschritt Farbsignale erzeugt, die sich auf die entsprechenden Ausgänge eines ersten Pixels (Pr), zweiten Pixels (Pg1) und dritten Pixels (Pb) stützen, und wobei in dem Signalverarbeitungsschritt die Farbsignale auf der Grundlage von vier Farbkomponenten (R, G1, G2 und B) erzeugt werden, welche der Ausgang der vier Pixel (Pg2) und der entsprechenden Ausgänge sind, sobald der Ausgang des zweiten Pixels (Pg1) ein Sättigungsniveau erreicht und die Farbsignale (Pg2) auf der Grundlage von drei Farbkomponenten erzeugt werden, die der Ausgang des vierten Pixels (Pg2) und die entsprechenden Ausgänge sind, ausgenommen nur der Ausgang des zweiten Pixels (Pg1), wenn der Ausgang des zweiten Pixels (Pg1) das Sättigungsniveau erreicht.

8. Signalverarbeitungsverfahren nach Anspruch 7, **dadurch gekennzeichnet, dass** die Empfindlichkeit des vierten Pixels (Pg2) auf etwa die halbe Empfindlichkeit des zweiten Pixels (Pg1) eingestellt wird.

9. Signalverarbeitungsverfahren nach Anspruch 7 oder 8, **dadurch gekennzeichnet, dass** eine Wellenlängenspitze einer Empfindlichkeitscharakteristik des ersten Pixels (Pr) im Bereich von 590 nm bis 640 nm liegt; dass eine Wellenlängenspitze einer Empfindlichkeitscharakteristik des zweiten Pixels (Pg1) in dem Bereich von 520 nm bis 570 nm liegt; dass eine Wellenlängenspitze einer Empfindlichkeitscharakteristik des dritten Pixels (Pb) in dem Bereich von 430 nm bis 480 nm liegt; und dass eine Wellenlängenspitze einer Empfindlichkeitscharakteristik des vierten Pixels (Pg2) in einem der Bereiche liegt, die sich von 490 nm bis 530 nm und von 560 nm bis 640 nm erstrecken.

**Revendications**

1. Dispositif d'imagerie en couleurs comprenant un capteur d'image en couleurs dans lequel des blocs de pixels (B) sont arrangés dans une situation en réseau, une unité de traitement de signaux (11-16) pour générer des signaux de couleurs en se basant sur des sorties respectives d'un premier pixel (Pr), d'un second pixel (Pg1), et d'un troisième pixel (Pb), dans lequel lesdits blocs de pixels (B) incluent :

   ledit premier pixel (Pr) pour détecter la lumière rouge ;

ledit second pixel (Pg1) pour détecter la lumière verte ;

ledit troisième pixel (Pb) pour détecter la lumière bleue ; et

un quatrième pixel (Pg2) pour détecter la lumière ayant une des longueurs d'onde entre la lumière verte et la lumière bleue et entre la lumière verte et la lumière rouge,

la sensibilité de réception de lumière dudit second pixel (Pg1) est choisie plus élevée que la sensibilité de réception de lumière de l'un quelconque parmi ledit premier pixel (Pr), ledit troisième pixel (Pb) et ledit quatrième pixel (Pg2), ladite unité de traitement de signaux (11-16) génère les signaux de couleurs en se basant sur quatre composantes de couleur (R, G1, G2 et B) qui sont les sorties dudit quatrième pixel (Pg2) et lesdites sorties respectives quand la sortie dudit second pixel (Pg1) n'atteint pas un niveau de saturation, et génère les signaux de couleurs en se basant sur trois composantes de couleurs qui sont la sortie dudit quatrième pixel (Pg2) et lesdites sorties respectives en excluant la sortie dudit second pixel (Pg1) quand la sortie dudit second pixel (Pg1) atteint le niveau de saturation.

2. Dispositif d'imagerie en couleurs selon la revendication 1, **caractérisé en ce que** la sensibilité dudit quatrième pixel (Pg2) est choisie à environ la moitié de la sensibilité dudit second pixel (Pg1).

3. Dispositif d'imagerie en couleurs selon la revendication 1 ou 2, **caractérisé en ce qu'**une longueur d'onde de pointe d'une caractéristique de sensibilité dudit premier pixel (Pr) est dans la plage de 590 nm à 640 nm ; une longueur d'onde de pointe d'une caractéristique de sensibilité dudit second pixel (Pg1) est dans la plage de 520 nm à 570 nm ; une longueur d'onde de pointe d'une caractéristique de sensibilité dudit troisième pixel (Pb) est dans la plage de 430 à 480 nm ; et une longueur d'onde de pointe d'une caractéristique de sensibilité dudit quatrième pixel (Pg2) est dans l'une des plages de 490 nm à 530 nm et de 560 nm à 640 nm.

4. Dispositif d'imagerie en couleurs selon l'une des revendications 1 à 3, **caractérisé en ce qu'**une caractéristique de sensibilité dudit premier pixel (Pr) est fixée par une caractéristique de transmittance d'une première unité de filtre prévue dans ledit premier pixel (Pr), une caractéristique de sensibilité dudit second pixel (Pg1) est fixée par une caractéristique de transmittance d'une seconde unité de filtre prévue dans ledit second pixel (Pg1), une caractéristique de sensibilité dudit troisième pixel (Pb) est fixée par une caractéristique de transmittance d'une troisième unité de filtre prévue dans ledit troisième pixel (Pb), et une caractéristique de sensibilité dudit quatrième pixel (Pg2) est fixée par une caractéristique de transmittance d'une quatrième unité de filtre prévue dans ledit quatrième pixel (Pg2).

5. Dispositif d'imagerie en couleurs selon la revendication 4, **caractérisé en ce que** la transmissivité de ladite quatrième unité de filtre est fixée à environ la moitié de la transmissivité de ladite seconde unité de filtre.

6. Dispositif d'imagerie en couleurs selon la revendication 4 ou 5, **caractérisé en ce qu'**une longueur d'onde de pointe de la caractéristique de transmittance de ladite première unité de filtre dans une région de lumière visible est dans la plage de 590 nm à 640 nm ; une longueur d'onde de pointe de la caractéristique de transmittance de ladite seconde unité de filtre dans la région de lumière visible est dans la plage de 520 à 570 nm ; une longueur d'onde de pointe de la caractéristique de transmittance de ladite troisième unité de filtre dans la région de lumière visible est dans la plage de 430 nm à 480 nm ; et une longueur d'onde de pointe de la caractéristique de transmittance de ladite quatrième unité de filtre dans la région de lumière visible est dans l'une des plages de 490 nm à 530 nm et de 560 nm à 640 nm.

7. Procédé de traitement de signaux appliqué à un dispositif d'imagerie en couleurs comprenant un capteur d'image en couleurs dans lequel des blocs de pixel (B) sont arrangés dans une situation en réseau, lesdits blocs de pixel (B) incluent :

   ledit premier pixel (Pr) pour détecter la lumière rouge ;
   ledit second pixel (Pg1) pour détecter la lumière verte ;
   ledit troisième pixel (Pb) pour détecter la lumière bleue ; et
   un quatrième pixel (Pg2) pour détecter la lumière ayant l'une des longueurs d'onde entre la lumière verte et la lumière bleue et entre la lumière verte et la lumière rouge,
   la sensibilité de réception de lumière dudit second pixel (Pg1) est choisie plus élevée que la sensibilité de réception de lumière de l'un quelconque parmi ledit premier pixel (Pr), ledit troisième pixel (Pb) et ledit quatrième pixel (Pg2), ledit procédé de traitement de signaux comprenant
   une étape de traitement de signaux qui génère des signaux de couleur en se basant sur des sorties respectives d'un premier pixel (Pr), d'un second pixel (Pg1) et d'un troisième pixel (Pb), dans lequel dans ladite étape de traitement de signaux, les signaux de couleur sont générés en se basant sur quatre composantes de couleur (R, G1, G2 et B) qui sont la sortie dudit quatrième pixel (Pg2) et

lesdites sorties respectives quand la sortie dudit second pixel (Pg1) n'atteint pas un niveau de saturation, et les signaux de couleur sont générés en se basant sur trois composantes de couleurs qui sont la sortie dudit quatrième pixel (Pg2) et lesdites sorties respectives à l'exclusion de la sortie dudit second pixel (Pg1) uniquement quand la sortie dudit second pixel (Pg1) atteint le niveau de saturation.

8. Procédé de traitement de signaux selon la revendication 7, **caractérisé en ce que** la sensibilité dudit quatrième pixel (Pg2) est choisie à environ la moitié de la sensibilité dudit second pixel (Pg1).

9. Procédé de traitement de signaux selon la revendication 7 ou 8, **caractérisé en ce qu'**une longueur d'onde de pointe d'une caractéristique de sensibilité dudit premier pixel (Pr) est dans la plage de 590 nm à 640 nm ; une longueur d'onde de pointe d'une caractéristique de sensibilité dudit second pixel (Pg1) est dans la plage de 520 nm à 570 nm ; une longueur d'onde de pointe d'une caractéristique de sensibilité dudit troisième pixel (Pb) est dans la plage de 430 nm à 480 nm ; et une longueur d'onde de pointe d'une caractéristique de sensibilité dudit quatrième pixel (Pg2) est dans l'une des plages de 490 nm à 530 nm, et de 560 nm à 640 nm.

# Fig. 1

(R, G1, G2, B)　(R, G, B)

# Fig. 2

(a)

(b)

# Fig. 3

# Fig. 4

# Fig. 5

```
                    ┌──────────────┐
                    │    start     │
                    └──────┬───────┘
                           │
                           ▼
                      ╱─────────╲   S11
                  ╱──  G1<       ──╲   NO
                 ◁   threshold value  ▷──────────────┐
                  ╲──     ?       ──╱                 │
                      ╲─────────╱                     ▼
                           │                    ╱──────────╲   S12
                          YES              ╱──   G1<         ──╲   NO
                           │              ◁  saturation level   ▷────────────┐
                           │               ╲──      ?       ──╱              │
                           │                   ╲──────────╱                  │
                           │                        │                        │
                           │                       YES                       │
                           │                        │                        │
                           │                        ▼         S32            ▼         S33
                           │               ┌──────────────────┐   ┌──────────────────┐
                           │               │  white balance   │   │  white balance   │
                           │               │  reprocessing    │   │  reprocessing    │
                           │               └────────┬─────────┘   └────────┬─────────┘
                           │                        │                       │
                           ▼            S21          ▼          S22          ▼           S23
                 ┌──────────────────┐   ┌──────────────────┐   ┌──────────────────┐
                 │ sets up matrix A │   │ sets up matrix B │   │ sets up matrix C │
                 │  that reflects   │   │ which is between │   │ that reflects G2 │
                 │  both G1 and G2  │   │   matrix A and   │   │  instead of G1   │
                 └────────┬─────────┘   │    matrix C      │   └──────────────────┘
                          │             └──────────────────┘
                          ▼
                    ┌──────────────┐
                    │     end      │
                    └──────────────┘
```

**EP 1 575 304 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002271804 A
- JP 2001016598 A
- JP 3174890 A